# EUROPÄISCHE PATENTSCHRIFT

(11) **EP 0 909 341 B1**
(45) Veröffentlichungstag und Bekanntmachung des Hinweises auf die Patenterteilung: **18.04.2001**
(21) Anmeldenummer: 97928109.4
(22) Anmeldetag: 30.05.1997
(51) Int. Cl.: C23C 14/32, H01L 21/285, H01L 21/443

(54) **VERFAHREN ZUR HERSTELLUNG VON METALLISIERUNGEN AUF HALBLEITERKÖRPERN**
PROCESS FOR THE PRODUCTION OF METALLIC COATINGS ON SEMICONDUCTOR STRUCTURES
PROCEDE POUR L'OBTENTION DE COUCHES METALLISEES SUR DES CORPS SEMI-CONDUCTEURS

(30) Priorität: 31.05.1996 DE 19621855
(43) Veröffentlichungstag der Anmeldung: 21.04.1999
(73) Patentinhaber: Technische Universität Dresden, 01069 Dresden (DE); FRAUNHOFER-GESELLSCHAFT ZUR FÖRDERUNG DER ANGEWANDTEN FORSCHUNG E.V., 80636 München (DE)
(72) Erfinder: KLIMES, Wolfgang, D-01279 Dresden (DE); WENZEL, Christian, D-01239 Dresden (DE); URBANSKY, Norbert, D-01169 Dresden (DE); SIEMROTH, Peter, D-01099 Dresden (DE); SCHÜLKE, Thomas, D-01129 Dresden (DE); SCHULTRICH, Bernd, D-01257 Dresden (DE)
(86) Internationale Anmeldenummer: DE9701081
(87) Internationale Veröffentlichungsnummer: WO9746728

(56) Entgegenhaltungen:
- EP-A- 0 275 018
- US-A- 5 013 578
- US-A- 5 401 543
- US-A- 5 502 004

## Beschreibung

Die Erfindung betrifft ein Verfahren zur Metallisierung von Halbleiterkörpern, womit Bereiche der Oberfläche mittels Leiterbahnen in einer oder mehreren Ebenen und Kontakten zwischen den Leiterbahnen verschiedener Ebenen elektrisch leitend verbunden werden können. Bei ansteigender Dichte und Komplexität auf dem Chip werden die Forderungen an das Metallisierungsverfahren stetig höher. Es sind eine immer größere Anzahl von Leiterbahnen in den einzelnen Ebenen und die notwendigen Kontakte zwischen den Leiterbahnen zu realisieren. Dazu werden ständig schmalere Leiterbahnen und kleinere Kontaktflächen verwendet. Die sich daraus ergebende Strukturfeinheit für die Metallisierung der höchstintegrierten Bauelemente erfordert besonders angepaßte Verfahren.

Ein Teil der Verfahren scheidet das Leiterbahnmaterial ganzflächig auf die ebenen Substrate ab. Die Strukturierung geschieht mittels Rückätzen und Benutzen von Masken. Andere Verfahren scheiden das Leiterbahnmaterial und Kontaktmaterial auf Substraten ab, deren Oberfläche die Gräben und Löcher für die Leiterbahnen und Kontakte bereits besitzen. Ein z.B. nachfolgender CMP-Prozeß beseitigt das überflüssige Leitermaterial außerhalb der Gräben und Löcher. Besondere Schwierigkeiten bereitet hierbei das konforme Abscheiden einer Adhäsions- und Barriereschicht auf die Oberfläche der Gräben und Löcher und das anschließende Füllen der Gräben und Löcher. Ursache hierfür sind die ständig geringer werdenden Strukturbreiten bei einem gleichzeitig wachsenden Aspektverhältnis. Einige Verfahren benutzen CVD-Prozesse. So werden in der US 4900695 physikalisch unterstützte CVD-Prozesse eingesetzt. CVD-Prozesse sind in ihrer technischen Realisierung im allgemeinen kostenaufwendig und ihre Handhabung ist unter Umweltgesichtspunkten nicht unproblematisch. In der US 5108951 wird die Metallisierung bei höheren Temperaturen und kleineren Abscheideraten vorgenommen und damit eine höhere Beweglichkeit der Atome des Beschichtungsmaterials zur vollständigen Graben- und Lochfüllung ausgenutzt. Ungünstig bei diesem Verfahren ist die geringe Effizienz und die Beschränkung auf kleine Aspektverhältnisse. DE 3925603 beschreibt die Herstellung von schmalen Leiterbahnen auf relativ ebenem Trägermaterial durch anisotropes Ätzen des ganzflächig abgeschiedenen Trägermaterials an einer zuvor geschaffenen Stufe. Als Nachteil ist die Notwendigkeit eines zweiten Prozeßschrittes, das anisotrope Ätzen, anzusehen. Mit Hilfe eines Kollimators beim Sputterbeschichten erfolgt nach US 5401675 eine Barriereherstellung bei großen Aspektverhältnissen. Nachteil dieses Verfahrens ist die mit dem Aspektverhältnis wachsende Inhomogenität bzw. Ineffizienz. Letzteres gilt insbesondere für das Auffüllen mit Leitermaterial. Bekannt ist weiterhin die Anwendung einer Nachionisation der gesputterten Metallatome in einem durch ein HF-Feld erzeugten Plasma, dabei erfolgt die Einkopplung des HF-Feldes induktiv (S.M. Rossnagel und J. Hopwood, Journ. Vac. Sci. Technol. B 12 (1), Jan/Feb 1994, Seiten 449-453). Nach US 5302266 ermöglicht die Nachionisation von Metallatomen mittels ECR-Plasmen das Füllen von Strukturen mit großen Aspektverhältnissen. Diese Verfahren erscheinen apparativ sehr aufwendig. Abweichend zu den obig geschilderten PVD-Verfahren wird nach G. A. Dixit, W. Y. Hamamoto, M. K. Jain, L. M. Ting, R. H. Havemann, C. D. Dobson, A. I. Jeffryes, P. J. Holverson, P. Rich, D. C, Butler und J. Hems, SEMICONDUCTOR INTERNATIONAL; August 1995, Seiten 79-85, die Bildung von Hohlräumen beim Füllen der Strukturen mit großen Aspektverhältnissen mittels konventioneller Sputterbeschichtung in Kauf genommen. In einem nachfolgenden Prozeßschritt werden die Hohlräume im Inneren mit dem hohen Druck eines Inertgases und hoher Temperatur auf die geschlossene Oberfläche des beschichteten Halbleiterkörpers beseitigt. Nachteilig erscheinen zwei erforderliche Prozeßschritte mit sehr unterschiedlichen technologischen Ausrüstungen.
Aus der US 5013578 ist eine Vorrichtung und ein Verfahren zum Beschichten von Oberflächen mittels eines gepulsten Vakuumlichtbogens bekannt, bei dem das Substrat mit einem zusätzlichen Bias während der Beschichtung versehen wird. Die Vorrichtung wird zum Yttrium-Implantieren verwendet.

Die Aufgabe der Erfindung besteht darin, auf bereits strukturierten planaren mikroelektronischen Substraten die erzeugten Gräben bzw. Löcher zu füllen, um Bereiche der Oberfläche in einer oder mehreren Ebenen leitend miteinander zu verbinden. Dabei sollen die vorstehend beschriebenen Nachteile bekannter Verfahren vermieden werden.

Erfindungsgemäß wird die Aufgabe mit einem Verfahren nach den Merkmalen des Anspruchs 1 gelöst. Vorteilhafte Varianten des Verfahrens werden in den Ansprüchen 2 - 18 angegeben.

Es wurde überraschend gefunden, daß mit Hilfe eines an sich bekannten gepulsten Vakuumbogenverdampfers in erzeugten Gräben für die Leiterbahnen und Löchern für Leiterbahnverbindungen im Substratmatrial, wie z.B. SiO₂ oder anderen anorganischen und organischen Werkstoffen, Barriere- und/oder niederohmiges Leiterbahnmaterial aus der Dampfphase eines derartigen Verdampfers abgeschieden werden kann.

Der hohe Ionisationsgrad und die hohe Teilchenenergie ermöglichen sowohl das notwendig konforme Beschichten mit Barrierematerial als auch das nachfolgende Füllen mit Leiterbahnmaterial der Gräben und Löcher mit hohen Aspektverhältnissen. Die Barriereschichten zeichnen sich durch eine geringe Defektdichte aus. Weitere Merkmale der Erfindung zur Bildung einer Barriereschicht sind das Einlassen von Inertgasen, wie z.B. Argon, und/oder Reaktionsgasen, wie z.B. Stickstoff, in den Rezipienten, damit sich eine weitgehend konforme Abscheidung und die jeweilige Schichtzusammensetzung ergeben. Eine zur Plasmaausbreitungsrichtung senkrechte, parallele oder schräge Anordnung der Substratoberfläche führt zu sehr unterschiedlichen Abscheideergebnissen innerhalb und außerhalb der Struktur. Die konforme Abscheidung kann bei paralleler oder schräger Anordnung durch Rotation der Substrate unterstützt werden.

Eine weitere Möglichkeit zur Barriereherstellung ergibt sich aus der Anordnung einer Blende zwischen Substrat und gepulsten Vakuumbogenverdampfer. Neben guter Konformität wird eine dropletfreie Abscheidung erreicht. Durch Anlegen einer Vorspannung an das Substrat bzw. an Substrat und Blende lassen sich die Abscheidebedingungen für das Barriere- und Leiterbahnmaterial wirksam beeinflussen.

Mit Hilfe einer Spule, die ein zum gepulsten Vakuumbogenverdampfer axiales Magnetfeld erzeugt, und der Vorspannung der Spuleninnenfläche wird die Effizienz erhöht und der Dropletanteil auf dem Substrat verringert. Zugleich werden die Bedingungen zum Ausfüllen der Gräben und Bohrungen mit hohen Aspektverhältnissen verbessert.

Eine weitere Möglichkeit den Dropletanteil zu verringern, besteht mit einem gepulsten Vakuumbogenverdampfer und einer Spule zur Anpassung der Plasmacharakteristik an eine nachfolgende Torusspule, deren Innenfläche vorgespannt ist. Eine Anpassung des Torusausganges an das Substrat mit Strukturen, die eine hohes Aspektverhältnis besitzen, ermöglicht eine weitere Spule.

Für extrem hohe Aspektverhältnisse erfolgt die Metallisierung bei materialtypisch höheren Substrattemperaturen oder ein nachfolgender zweiter Schritt beseitigt bzw. verringert die abgeschlossenen Hohlräume mit Hilfe von hohen Drücken eines Inertgases auf die Substratfläche bei gleichzeitig entsprechend hohen Temperaturen.

Der Vorteil der erfindungsgemäßen Lösung besteht darin, daß weitgehend dropletfreie dichte metallische Schichten auf mikrostrukturierten Substraten mit hohem Aspektverhältnis abgeschieden werden können. In Abhängigkeit von der Prozeßführung ist sowohl das komplette Füllen von Gräben mit einem Aspektverhältnis > 1 als auch das konturkonforme Abscheiden von Barriereschichten möglich.

Die Erfindung wird nachfolgend an Hand von mehreren Ausführungsbeispielen noch näher erläutert. In den Zeichnungen zeigen:
Fig. 1 einen vergrößerten Querschnitt durch eine Grabenvertiefung im Substrat
Fig. 2 eine Vorrichtung zur Durchführung des erfindungsgemäßen Verfahrens
Fig. 3 eine Vorrichtung mit zwei Substraten
Fig. 4 eine Vorrichtung mit parallel zur Mittenachse des Verdampfers angeordnetem Substrat
Fig. 5 eine Vorrichtung mit Blende zwischen Verdampfer und Substrat
Fig. 6 eine Darstellung zur Veranschaulichung der Herstellung der Barriereschicht und der Herstellung der Metallisierung in den Gräben und Löchern
Fig. 7 eine Vorrichtung mit Spule zwischen Verdampfer und Substrat
Fig. 8 eine Vorrichtung mit gekrümmter Spule zwischen Verdampfer und Substrat

### Ausführungsbeispiel 1

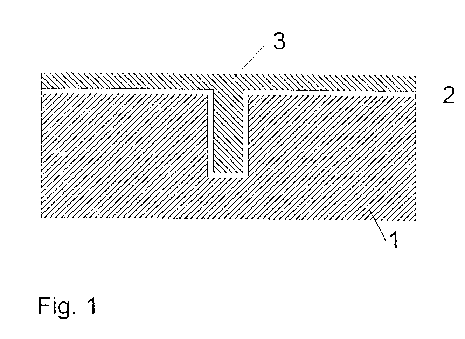

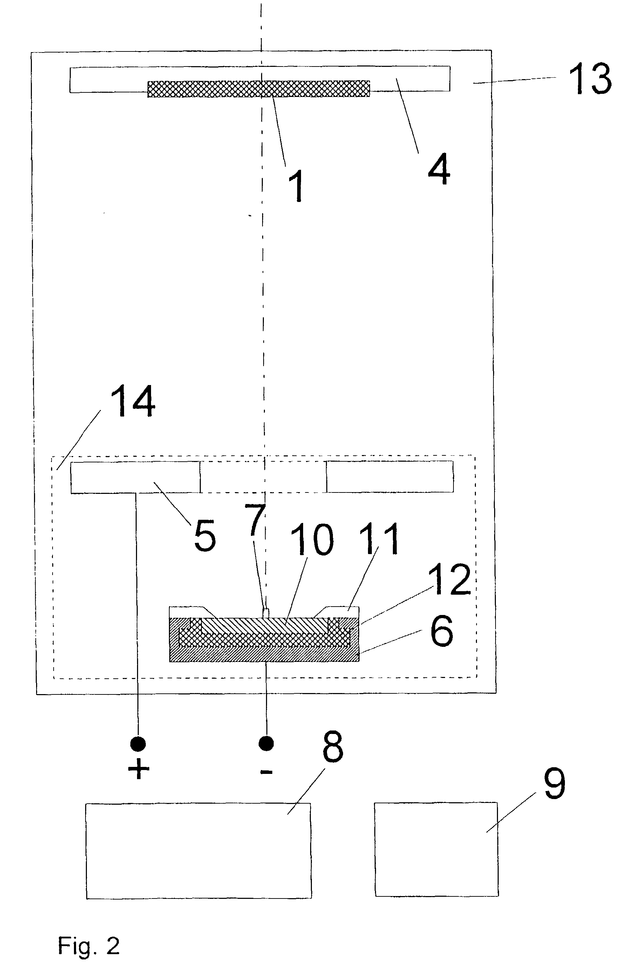

Die Fig. 1 zeigt einen stark vergrößerten Querschnitt einer Grabenvertiefung in einem Substrat 1. Nachdem in einem vorangegangenen Prozeß eine Diffusionsbarriere 2 aufgebracht wurde, soll durch eine Vorrichtung eine Kupferbeschichtung 3 aufgebracht werden, die die Vertiefungen vollständig ausfüllt. Das Aspektverhältnis dieser Vertiefungen ist dabei größer als eins. Die Vorrichtung und das Verfahren werden an Hand von Fig. 2 erläutert. Zur Metallisierung wird jeweils ein Substrat 1 durch übliche Probenmanipulatoren in die Vakuumkammer 13 eingebracht und gegenüber dem als Verdampfer fungierenden gepulsten Vakuumbogenverdampfer 14 in der Beschichtungsposition auf dem auf 200° C stabilisierten Substrathalter 4 positioniert. Der gepulste Vakuumbogenverdampfer 14 besteht aus Anode 5, Kathode 6, dem im Zentrum der Kathode angeordneten Zündstift 7, der außerhalb des Vakuumrezipienten angeordneten Impulsstromquelle 8 und der Prozeßsteuerelektronik 9. Der aktive Bereich 10 der Kathode 6 (das sogenannte Target 10) besteht aus Kupfer und kann regelmäßig nach Behandlung mehrerer hundert Substrate gewechselt werden. Das eigentliche Target 10, - eine runde Scheibe aus Kupfer - wird durch eine Klemmvorrichtung 11 auf den gekühlten Kathodenkörper gepreßt, um einen verlustarmen Stromübertritt und eine gute Wärmeableitung zu gewährleisten. Mehrere Targets 10 mit den jeweiligen Zündstiften 7 sind hintereinander in einem Targetschlitten 12 montiert, der bei Bedarf verschoben werden kann (in Fig. 2 senkrecht zur Bildebene). Der Abstand zwischen Verdampfer 14 und dem Substrat 1 beträgt mindestens das 4-fache des Substratdurchmessers, im vorliegenden Fall 100cm. Bei der Beschichtung ist das Substrat 1 so angeordnet, daß die durch seine Mitte verlaufende Normale genau auf das Zentrum des Verdampfers 14 ausgerichtet ist. Nachdem durch die Probenmanipulatoren das Substrat 1 in die Beschichtungsposition gebracht wurde, wird der Verdampfer 14 in Betrieb genommen. Um die 1 µm tiefen Gräben und Löcher zu füllen, werden 25.000 Entladungen des Verdampfers 14 ausgelöst, was bei einer Pulsfolgefrequenz von 50 Hz ca. 8 Minuten und 20 Sekunden dauert. Anschließend wird das Substrat durch die Probenbewegungseinrichtung vom Probenhalter entnommen und zur nächsten Prozeßkammer weiterbewegt, wo durch herkömmliches chemisch-mechanisches Polieren überflüssige Beschichtungen entfernt werden.

### Ausführungsbeispiel 2

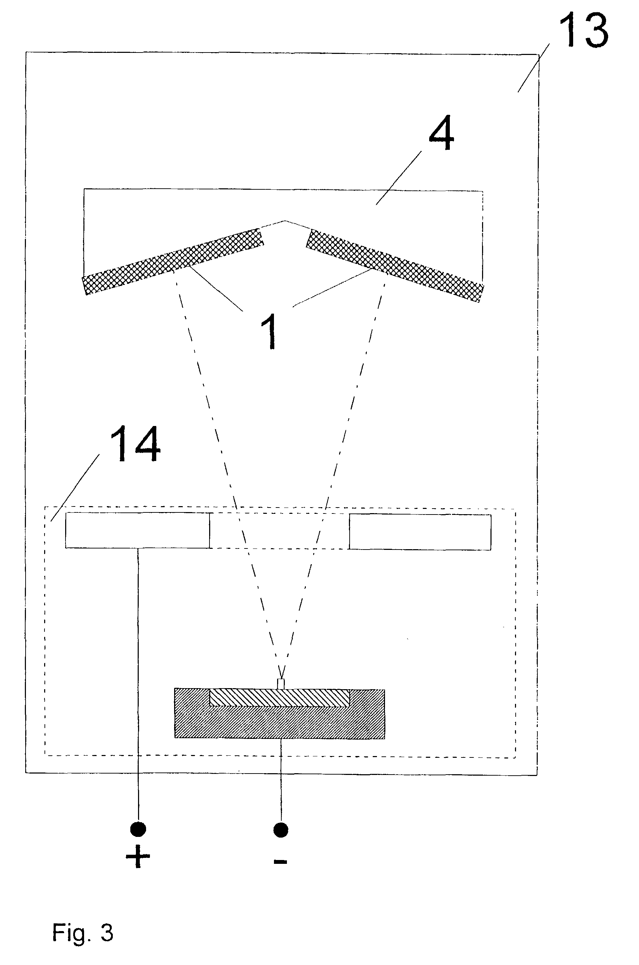

Wie im Ausführungsbeispiel 1 sollen auf bereits strukturierten und mit einer Barriereschicht bedeckten planaren mikroelektronischen Substraten mit Durchmessern von mindestens 20 cm Gräben bzw. Löcher gefüllt werden, um Bauelemente verschiedener Ebenen leitend zu verbinden. Dabei sollen im Ausführungsbeispiel 2 mehrere Substrate 1 gleichzeitig behandelt werden. Die Vorrichtung ist in Fig. 3 schematisch dargestellt. Zur Metallisierung werden die Substrate 1 durch übliche Probenmanipulatoren in die Vakuumkammer 13 eingebracht und gegenüber dem Verdampfer 14 in die Beschichtungspositionen auf die auf 200° C stabilisierten Substrathalter 4 positioniert. Der gepulste Vakuumbogenverdampfer 14 ist identisch mit dem im Beispiel 1 beschriebenen. Der Abstand zwischen Verdampfer 14 und den Substraten 1 beträgt auch hier mindestens das 4-fache des Substratdurchmessers, im vorliegenden Fall 100 cm. Bei der Beschichtung sind die Substrate 1 so angeordnet, daß die Mittelachsen jedes der Substrate 1 auf die Mitte des Verdampfers 14 ausgerichtet sind. Nachdem durch die Probenmanipulatoren die Substrate 1 in diese Beschichtungspositionen gebracht wurden, wird der Verdampfer 14 in Betrieb genommen. Um die 1 µm tiefen Gräben und Löcher zu füllen, werden 35.000 Entladungen des Verdampfers ausgelöst. Dieser Prozeß dauert bei einer Pulsfolgefrequenz von 50 Hz 11 Minuten und 40 Sekunden. Anschließend werden die Substrate durch die Probenbewegungseinrichtung von den Probenhaltern entnommen und zur nächsten Prozeßkammer weiterbewegt, wo durch herkömmliches chemisch-mechanisches Polieren überflüssige Beschichtungen entfernt werden.

### Ausführungsbeispiel 3

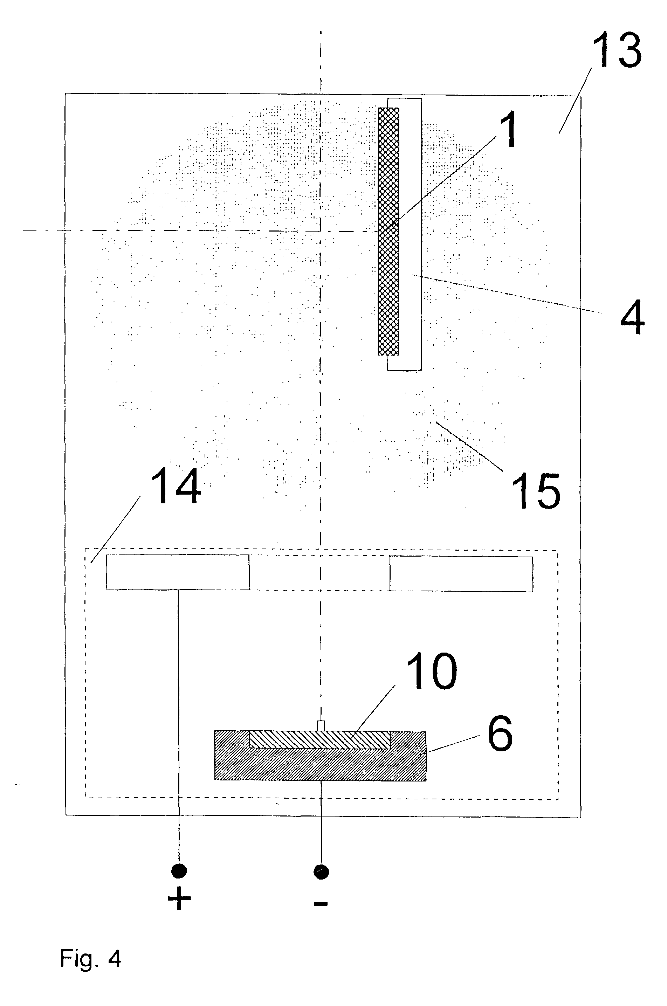

Im Ausführungsbeispiel 3 werden auf bereits strukturierten planaren mikroelektronischen Substraten mit Durchmessern von mindestens 20 cm dünne konforme Barriereschichten an den Wandflächen von Gräben bzw. Löchern abgeschieden, um in einem nachfolgenden Arbeitsschritt (wie in Ausführungsbeispiel 1 oder 2 beschrieben) diese Vertiefungen auszufüllen. Das Aspektverhältnis dieser Vertiefungen ist dabei größer als eins. Die Vorrichtung ist in Fig. 4 schematisch dargestellt. Zur Behandlung wird jeweils ein Substrat 1 durch übliche Probenmanipulatoren in die Vakuumkammer 13 eingebracht und gegenüber dem Verdampfer 14 parallel zur Mittelachse des Verdampfers in der Beschichtungsposition auf dem Substrathalter 4 positioniert. Der gepulste Vakuumbogenverdampfer 14 ist identisch mit dem im Beispiel 1 beschriebenen. Der aktive Bereich 10 der Kathode 6 (das sogenannte Target 10) besteht aus Tantal und kann regelmäßig nach Behandlung mehrerer hundert Substrate gewechselt werden. Zur Beschichtung wird in die Vakuumkammer 13 ein Gasgemisch aus Argon und Stickstoff eingelassen, bis der Arbeitsdruck von 0,5 Pa erreicht ist. Der Abstand zwischen Verdampfer 14 und dem Substrat 1 beträgt im vorliegenden Fall 50 cm. Nachdem durch die Probenmanipulatoren das Substrat 1 in die Beschichtungsposition gebracht wurde, wird der Verdampfer 14 in Betrieb genommen. Um Seiten- und Bodenflächen der 1 µm tiefen Gräben und Löcher mit einer 50 nm dicken Barriereschicht aus TaN zu überziehen, werden 12.500 Entladungen des Verdampfers ausgelöst, was bei einer Pulsfolgefrequenz von 50 Hz 4 Minuten und 10 Sekunden dauert. Anschließend wird das Substrat durch die Probenbewegungseinrichtung vom Probenhalter entnommen und zur nächsten Prozeßkammer weiterbewegt.

### Ausführungsbeispiel 4

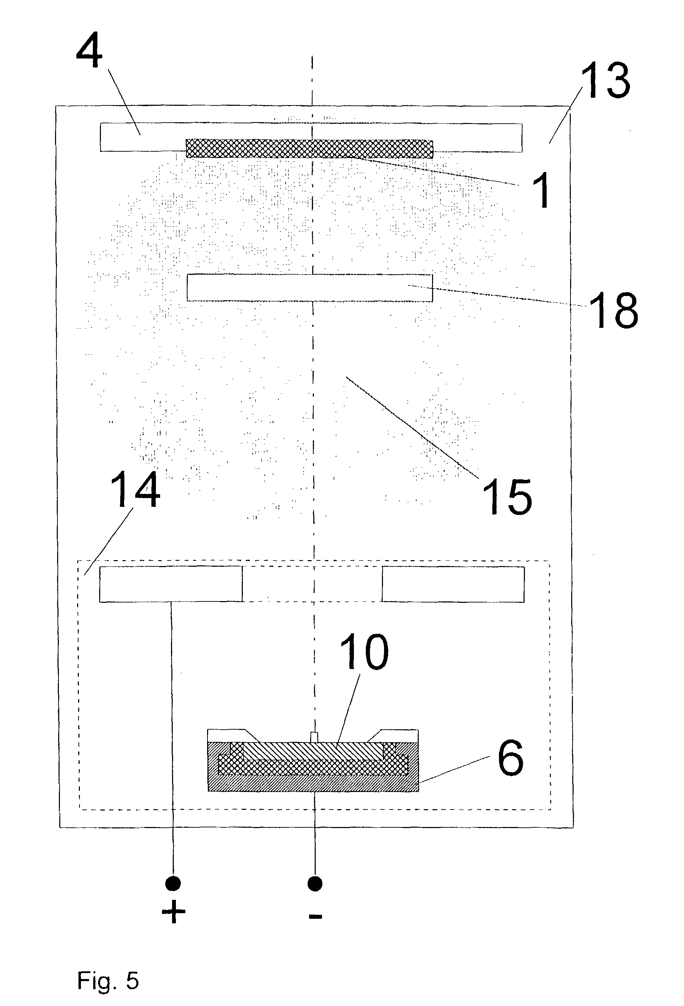

Im Ausführungsbeispiel 4 werden auf bereits strukturierten planaren mikroelektronischen Substraten mit Durchmessern von mindestens 20 cm dünne konforme Barriereschichten an den Wandflächen von Gräben bzw. Löchern abgeschieden, um in einem nachfolgenden Arbeitsschritt (wie in Ausführungsbeispiel 1 oder 2 beschrieben) diese Vertiefungen auszufüllen. Das Aspektverhältnis dieser Vertiefungen ist dabei größer als eins. Die Vorrichtung ist in Fig. 5 schematisch dargestellt. Zur Behandlung wird jeweils ein Substrat 1 durch übliche Probenmanipulatoren in die Vakuumkammer 13 eingebracht und gegenüber dem Verdampfer 14 parallel zur Mittelachse des Verdampfers in der Beschichtungsposition auf dem Substrathalter 4 positioniert. Zwischen Verdampfer 14 und Substrathalter 4 ist eine gegenüber der Kathode vorgespannte Blende 18 dergestalt angebracht ist, daß die gesamte Substratfläche gegenüber dem Verdampfer 14 abgedeckt ist. Der gepulste Vakuumbogenverdampfer 14 ist identisch mit dem im Beispiel 1 beschriebenen. Der aktive Bereich 10 der Kathode 6 (das sogenannte Target 10) besteht aus Tantal und kann regelmäßig nach Behandlung mehrerer hundert Substrate gewechselt werden. Zur Beschichtung wird in die Vakuumkammer 13 ein Gasgemisch aus Argon und Stickstoff eingelassen, bis der Arbeitsdruck von 0,5 Pa erreicht ist. Der Abstand zwischen Verdampfer 14 und Blende 18 sowie zwischen Blende 18 und dem Substrat 1 beträgt im vorliegenden Fall jeweils 50 cm. Nachdem durch die Probenmanipulatoren das Substrat 1 in die Beschichtungsposition gebracht wurde, wird der Verdampfer 14 in Betrieb genommen. Um Seiten- und Bodenflächen der 1 µm tiefen Gräben und Löcher mit einer 50 nm dicken Barriereschicht aus TaN zu überziehen, werden 62.500 Entladungen des Verdampfers ausgelöst, was bei einer Pulsfolgefrequenz von 200 Hz 5 Minuten und 12 Sekunden dauert. Anschließend wird das Substrat durch die Probenbewegungseinrichtung vom Probenhalter entnommen und zur nächsten Prozeßkammer weiterbewegt.

### Ausführungsbeispiel 5

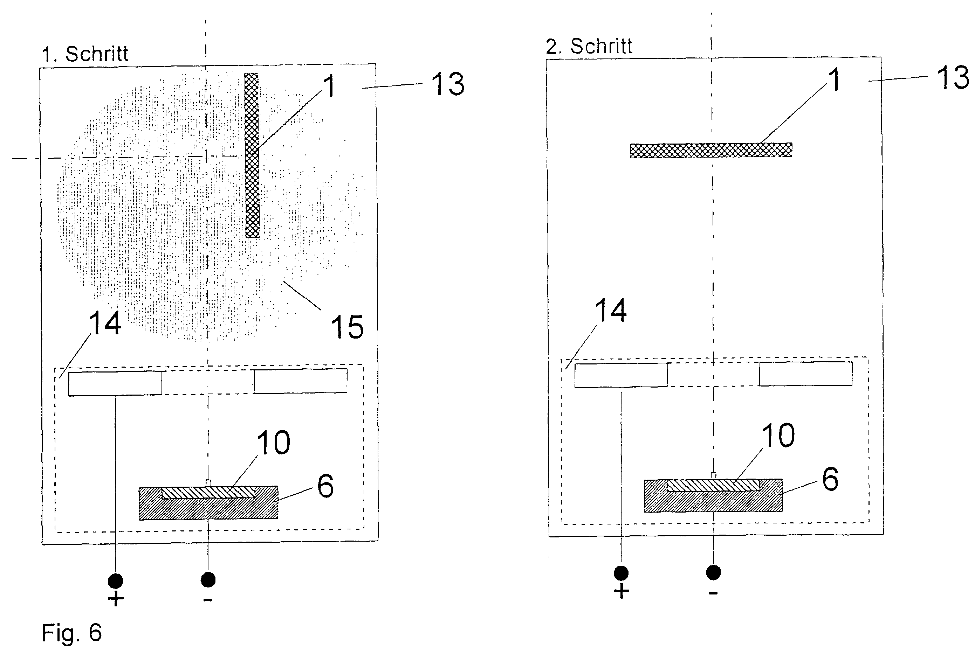

Im Ausführungsbeispiel 5 werden auf bereits strukturierten planaren mikroelektronischen Substraten mit Durchmessern von mindestens 20 cm dünne konforme Barriereschichten an den Wandflächen von Gräben bzw. Löcher abgeschieden, und im nächsten Arbeitsschritt diese Vertiefungen ausgefüllt. Beide Arbeitsschritte sollen in der gleichen Vakuumkammer ohne Zwischenbelüftung ausgeführt werden. Das Aspektverhältnis dieser Vertiefungen ist dabei größer als eins. Die Vorrichtung und das entsprechende erfindungsgemäße Verfahren sind in Fig. 6 schematisch dargestellt. Zur Abscheidung der Barriereschicht wird jeweils ein Substrat 1 durch übliche Probenmanipulatoren in die Vakuumkammer 13 eingebracht und gegenüber dem Verdampfer 14 parallel zur Mittelachse des Verdampfers in der Beschichtungsposition auf dem Substrathalter 4 positioniert. Der gepulste Vakuumbogenverdampfer 14 ist identisch mit dem im Beispiel 1 beschriebenen. Der aktive Bereich 10 der Kathode 6 (das sogenannte Target 10) besteht im ersten Prozeßschritt aus Tantal. Zur Beschichtung wird in die Vakuumkammer 13 ein Gasgemisch aus Argon und Stickstoff eingelassen, bis der Arbeitsdruck von 0,5 Pa erreicht ist. Der Abstand zwischen Verdampfer 14 und dem Substrat 1 beträgt im vorliegenden Fall 100 cm. Nachdem durch die Probenmanipulatoren das Substrat 1 in die Beschichtungsposition gebracht wurde, wird der Verdampfer 14 in Betrieb genommen. Um Seiten- und Bodenflächen der 1 µm tiefen Gräben und Löcher mit einer 50 nm dicken Barriereschicht aus TaN zu überziehen, werden 12.500 Entladungen des Verdampfers ausgelöst, was bei einer Pulsfolgefrequenz von 50 Hz genau 4 Minuten und 10 Sekunden dauert. Anschließend wird das Substrat durch die Probenbewegungseinrichtung zusammen mit dem Probenhalter um 90° gedreht, und der Substrathalter 4 auf 200° C geheizt. Das Tantaltarget wird aus dem aktiven Bereich 10 der Kathode 6 herausgeschoben und ein neues Target 10, bestehend aus Kupfer eingeschoben. Nachdem durch die Probenmanipulatoren das Substrat 1 in neue Beschichtungsposition gebracht wurde, wird das Gasgemisch aus Argon und Stickstoff abgepumpt und der Verdampfer 14 in Betrieb genommen. Um die 1 µm tiefen Gräben und Löcher zu füllen, werden 25.000 Entladungen des Verdampfers ausgelöst, was bei einer Pulsfolgefrequenz von 50 Hz 8 Minuten und 20 Sekunden dauert. Anschließend wird das Substrat durch die Probenbewegungseinrichtung vom Probenhalter entnommen und zur nächsten Prozeßkammer weiterbewegt, wo durch herkömmliches chemisch-mechanisches Polieren überflüssige Beschichtungen entfernt werden.

### Ausführungsbeispiel 6

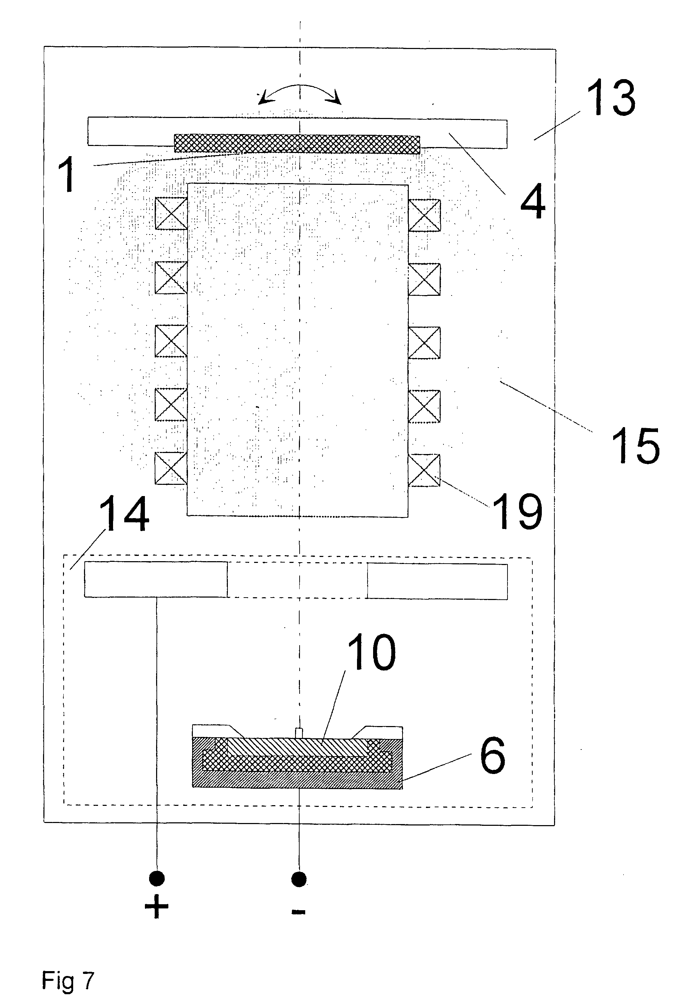

Im Ausführungsbeispiel 6 werden auf bereits strukturierten planaren mikroelektronischen Substraten mit Durchmessern von mindestens 20 cm dünne konforme Barriereschichten an den Wandflächen von Gräben bzw. Löcher abgeschieden, und im nächsten Arbeitsschritt diese Vertiefungen ausgefüllt. Beide Arbeitsschritte sollen in der gleichen Vakuumkammer ohne Zwischenbelüftung ausgeführt werden. Das Aspektverhältnis dieser Vertiefungen ist dabei größer als eins. Die Abscheidungen sollen mit hoher Rate erfolgen. Gleichzeitig wird gefordert, daß beide Schichten möglichst wenig Makropartikel enthalten. Die Vorrichtung ist in Fig. 7 schematisch dargestellt. Zur Abscheidung der Barriereschicht 2 wird jeweils ein Substrat 1 durch übliche Probenmanipulatoren in die Vakuumkammer 13 eingebracht und auf einem rotierbaren Substrathalter 4 positioniert, der gegenüber dem Verdampfer 14 das Substrat 1 parallel zur Mittelachse dieser Quelle bzw. senkrecht dazu ausrichten kann. Der gepulste Vakuumbogenverdampfer 14 ist identisch mit dem im Beispiel 1 beschriebenen. Der aktive Bereich 10 der Kathode 6 (das sogenannte Target 10) besteht im ersten Prozeßschritt aus Tantal. Zur Beschichtung wird in die Vakuumkammer ein Gasgemisch aus Argon und Stickstoff eingelassen, bis der Arbeitsdruck von 0,5 Pa erreicht ist. Der Abstand zwischen Verdampfer 14 und dem Substrat 1 beträgt im vorliegenden Fall 100cm. Zwischen Verdampfer 14 und Substrathalter 4 ist eine Spule 19 eingebaut. Die Mittelachse der Spule 19 fällt zusammen mit der Mittelachse des Verdampfers 14. Die Spule 19 besteht aus einer Windungslage Kupferrohr (Durchmesser 10 mm, Wandstärke 2mm), welches von Kühlwasser durchströmt wird und mit keramischen Isolatoren an den Wänden der Vakuumkammer 13 befestigt wird. Sie hat eine Länge von 50 cm, besteht aus 30 Windungen und wird von einem Gleichstrom von 200 A durchströmt. Der Innendurchmesser der Spule beträgt 25 cm. Nachdem durch die Probenmanipulatoren das Substrat 1 in die erste Beschichtungsposition gebracht (parallel zur Mittelachse des Verdampfers 14) wurde, wird der Verdampfer in Betrieb genommen. Um Seiten- und Bodenflächen der 1 µm tiefen Gräben und Löcher mit einer 50 nm dicken Barriereschicht 2 aus TaN zu überziehen, werden 7.500 Entladungen des Verdampfers ausgelöst, was bei einer Pulsfolgefrequenz von 50 Hz 2 Minuten und 30 Sekunden dauert. Anschließend wird das Substrat durch die Probenbewegungseinrichtung zusammen mit dem Probenhalter um 90° gedreht, und der Substrathalter 4 auf 200° C geheizt. Das Tantaltarget 10 wird aus dem aktiven Bereich 10 der Kathode 6 herausgeschoben und ein neues Target 10, bestehend aus Kupfer eingeschoben. Anschließend wird durch die Probenmanipulatoren das Substrat 1 in neue Beschichtungsposition gebracht, so daß die Mittelachsen von Substrat 1 und Verdampfer 14 übereinstimmen. Nachdem das Gasgemisch aus Argon und Stickstoff abgepumpt wurde, wird der Verdampfer 14 in Betrieb genommen. Um die 1 µm tiefen Gräben und Löcher zu füllen, werden 15.000 Entladungen des Verdampfers 14 ausgelöst. Dies dauert bei einer Pulsfolgefrequenz von 50 Hz 5 Minuten. Anschließend wird das Substrat durch die Probenbewegungseinrichtung vom Probenhalter entnommen und zur nächsten Prozeßkammer weiterbewegt, wo durch herkömmliches chemisch-mechanisches Polieren überflüssige Beschichtungen entfernt werden.

### Ausführungsbeispiel 7

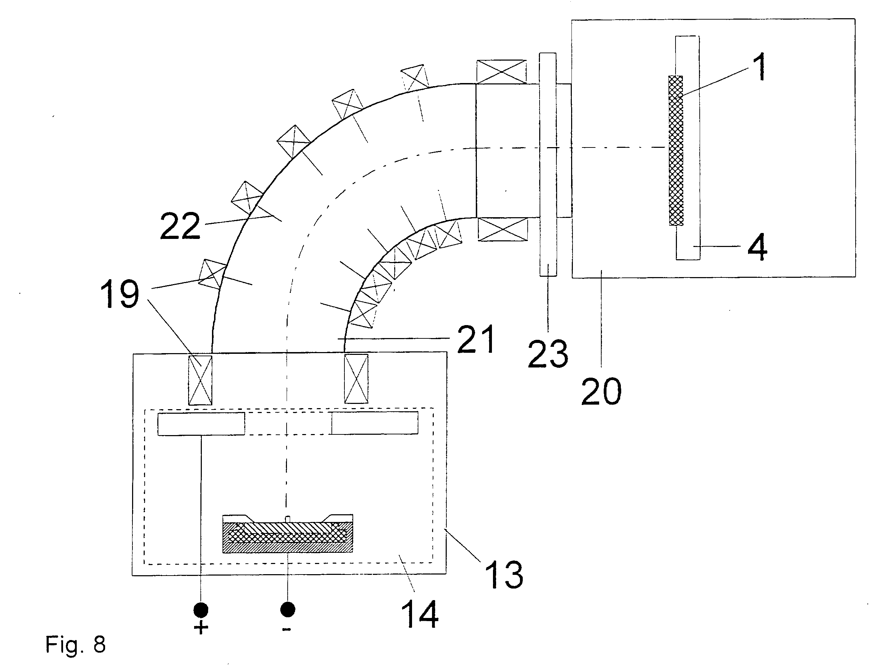

Im Ausführungsbeispiel 7 werden auf bereits strukturierten planaren mikroelektronischen Substraten mit Durchmessern von mindestens 20 cm Gräben bzw. Löcher mit Kupfer ausgefüllt. Das Aspektverhältnis dieser Vertiefungen ist dabei größer als eins. Insbesondere sind die Abscheidungen so auszuführen, das auf dem Substrat 1 keine Markropartikel abgeschieden werden und auch keine derartigen Partikel in den Beschichtungsraum gelangen können. Die Vorrichtung ist in Fig. 8 schematisch dargestellt. Eine Vakuumkammer 13, in der sich ein Verdampfer 14 befindet, wie sie in Beispiel 1 beschrieben wurde, wird mit dem Beschichtungsrezipienten 20 über einen rohrförmigen halbkreisförmig gebogenen Zwischenrezipienten 21 verbunden, dessen Innendurchmesser 20 cm und dessen Gesamtkrümmungsradius 60 cm beträgt. Um den Zwischenrezipienten 21 werden sieben koaxial montierte Spulen 19 mit jeweils 3000 Windungen montiert. Das Innere des Rohrrezipienten ist mit Ringscheiben 22 bedeckt, die Makropartikel, welche von dem Verdampfer 14 emittiert werden, zurückhalten. Um den Verdampfer- und den Zwischenrezipienten regelmäßig reinigen zu können, ohne das Vakuum in der Beschichtungskammer 20 zu beeinflussen, sind die Baugruppen durch ein Plattenventil 23 abtrennbar. Zur Abscheidung der Schicht wird jeweils ein Substrat 1 durch übliche Probenmanipulatoren in die Beschichtungskammer 20 eingebracht und gegenüber der Eintrittsöffnung senkrecht zur Mittelachse dieser Öffnung in der Beschichtungsposi-tion auf dem Substrathalter 4 positioniert. Der Abstand zwischen Eintrittsöffnung und dem Substrat 1 beträgt im vorliegenden Fall 30 cm. Nachdem durch die Probenmanipulatoren das Substrat 1 in die Beschichtungsposition gebracht wurde, wird der Verdampfer 14 in Betrieb genommen. Um die 1 µm tiefen Gräben und Löcher zu füllen, werden 75.000 Entladungen des Verdampfers ausgelöst, was bei einer Pulsfolgefrequenz von 200 Hz 6 Minuten und 15 Sekunden dauert. Anschließend wird das Substrat durch die Probenbewegungseinrichtung vom Probenhalter entnommen und zur nächsten Prozeßkammer weiterbewegt.

### Bezugszeichenliste

1 - Substrat
2 - Barriereschicht
3 - Leiterbahnmaterial
4 - Substrathalter
5 - Anode
6 - Kathode
7 - Zündstift
8 - Impulsstromquelle
9 - Prozeßsteuerelektronik
10 - Target
11 - Klemmvorrichtung
12 - Targetschlitten
13 - Vakuumkammer
14 - gepulster Vakuumbogenverdampfer
15 - Plasma
16 - regelbare Einlaßöffnung
17 - regelbare Einlaßöffnung
18 - Blende
19 -Spule
20 - Beschichtungsrezipient
21 - Zwischenrezipient
22 - Ringscheibe
23 - Plattenventil

## Patentansprüche

1. Verfahren zur Herstellung von Metallisierungen auf Halbleiterkörpern mittels Abscheidung aus der Dampfphase im Vakuum, wobei die Abscheidung auf bereits strukturierten mikroelektronischen Substraten, wie SiO₂ oder anderen anorganischen und organischen Werkstoffen, in Gräben und Löcher im Substratmatrial erfolgt, **dadurch gekennzeichnet,** daß ein an sich bekannter gepulster Vakuumbogenverdampfer (14) verwendet wird, wobei eine Barriereschicht (2) auf der Oberfläche der Gräben und Löcher des Substrates (1) unter Verwendung des Plasmas des Verdampfers abgeschieden wird und/oder das Füllen der Gräben und Löcher mit Leiterbahnmaterial (3) aus einem weiteren Plasma eines derartigen Verdampfers (14) vorgenommen wird.

2. Verfahren nach Anspruch 1, dadurch gekennzeichnet, daß die Abscheidung der Barriereschicht (2) in einem Gas niederen Druckes erfolgt.

3. Verfahren nach Anspruch 2, dadurch gekennzeichnet, daß als Gas aus Inert- und/oder Reaktivgas verwendet wird.

4. Verfahren nach Anspruch 1, 2 oder 3, dadurch gekennzeichnet, daß das Plasma von einem an sich bekannten gepulsten Vakuumbogenverdampfers (14) erzeugt wird, der zumindest Anode (5), Kathode (6), Zündstift (7) und außerhalb einer Vakuumkammer (13) befindliche Impulsstromquelle (8) und Prozeßsteuerelektronik (9) umfaßt, wobei das Substrat (1) dem von der Kathode (6) und/oder der Anode (5) emittierten Plasma (15) ausgesetzt wird.

5. Verfahren nach Anspruch 4, dadurch gekennzeichnet, daß der Vakuumbogenverdampfer (14) mit Stromimpulsen betrieben wird, deren Amplitude mehr als 500 Ampere beträgt.

6. Verfahren nach Anspruch 4, dadurch gekennzeichnet, daß die Mittelachse des Vakuumbogenverdampfers (14) während der Emittierung des Plasmas auf das zu beschichtende Substrat (1) ausgerichtet ist.

7. Verfahren nach Anspruch 4, dadurch gekennzeichnet, daß die Mittelachse des Substrates (1) während der Emittierung des Plasmas auf den Vakuumbogenverdampfer (14) hin ausgerichtet ist.

8. Verfahren nach Anspruch 4, dadurch gekennzeichnet, daß bei gleichzeitiger Metallisierung mehrerer Substrate (1) die Mittelachsen jedes der Substrate (1) auf die Mitte des Vakuumbogenverdampfers (14) ausgerichtet sind.

9. Verfahren nach Anspruch 4, dadurch gekennzeichnet, daß während der Metallisierung, durch regelbare Einlaßöffnungen (16,17) in der Vakuumkammer (13), Inertgas und/oder Reaktivgas niedrigen Druckes dem Plasma (15) und durch Einlaßöffnung (17) Reaktivgas und/oder Inertgas dem Substrat (1) zugeführt wird.

10. Verfahren nach einem der Ansprüche 6 oder 9, dadurch gekennzeichnet, daß die gesamte Substratfläche gegenüber dem Verdampfer (14) durch eine Blende (18) zwischen Vakuumbogenverdampfer (14) und Substrat (1) abgedeckt wird.

11. Verfahren nach Anspruch 10, dadurch gekennzeichnet, daß Potentiale an Substrat (1) und/oder Blende (18) gegenüber der Kathode (6) eingestellt werden oder, daß Substrat (1) und/oder Blende (18) elektrisch voneinander isoliert betrieben werden.

12. Verfahren nach einem der Ansprüche 4 bis 11, dadurch gekennzeichnet, daß das Substrat (1) während der Metallisierung-bezüglich seiner Oberflächennormale einen rechten Winkel mit der Mittelachse des Vakuumbogenverdampfers (14) einnimmt.

13. Verfahren nach Anspruch 12, dadurch gekennzeichnet, daß das Substrat (1) während der Metallisierung um seine Mittelachse rotiert.

14. Verfahren nach einem der Ansprüche 1 bis 13, dadurch gekennzeichnet, daß die Metallisierung durch eine stromdurchflossene Spule (19) zwischen Vakuumbogenverdampfer (14) und Substrat (1) hindurch erfolgt, wobei deren Innendurchmesser größer oder gleich dem Substratdurchmesser ist.

15. Verfahren nach einem der Ansprüche 1 bis 13, dadurch gekennzeichnet, daß die Metallisierung durch eine gebogene stromdurchflossene Spule (19) zwischen Vakuumbogenverdampfer (14) und Substrat (1) hindurch erfolgt, wobei die Mittelachsen des Verdampfer (14) und die oder der Substrate (1) auf die Mitte der jeweiligen Spulenöffnung gerichtet sind.

16. Verfahren nach einem der Ansprüche 1 bis 13, dadurch gekennzeichnet, daß die Metallisierung durch mehrere, auf einem Bogen angeordnete, zwischen Vakuumbogenverdampfer (14) und Substrat (1) befindliche, stromdurchflossene Spulen (19) hindurch erfolgt, wobei die Mittelachsen des Verdampfers (14) und die des Substrates (1) auf die Mitte der jeweils dem Objekt gegenüberliegenden Spule (19) gerichtet sind.

17. Verfahren nach einem der Ansprüche 14 bis 16, dadurch gekennzeichnet, daß ein Zwischenrezipient (21) verwendet wird, bei dem sich die Spulen (19) außerhalb des Rezipienten (21) befinden.

18. Verfahren nach einem der Ansprüche 1 bis 9 und 12 bis 17, dadurch gekennzeichnet, daß das Substrat (1) isoliert ist oder bezüglich der Kathode (6) ein bestimmtes Potential eingestellt wird.

## Claims

1. Method for the production of metallizations on semi-conductor bodies by deposition from the vapour phase in a vacuum in which the deposition is carried out on previously structured microelectronic substrates, such as SiO₂ or other anorganic and organic materials, in trenches and holes in the substrate material **characterized in that** an actually known pulsed vacuum arc evaporator (14) is used and a barrier layer (2) is deposited on the surface of the trenches and holes of the substrate (1) using the plasma of the evaporator and/or the filling of the trenches and holes with conductor track material (3) from another plasma of such an evaporator (14) is carried out.

2. Method to Claim 1 characterized in that the deposition of the barrier layer (2) takes place in a low-pressure gas.

3. Method to Claim 2 characterized in that an inert and/or reactive gas is used as the gas.

4. Method to Claim 1, 2 or 3 characterized in that the plasma is generated by an actually known pulsed vacuum arc evaporator (14) that includes, at least, anode (5), cathode (6), ignition pin (7), pulsed current source (8) located outside of the vacuum chamber (13) and electronic process control equipment (9) with the substrate (1) being exposed to the plasma (15) emitted from the cathode (6) and/or the anode (5).

5. Method to Claim 4 characterized in that the vacuum arc evaporator (14) is operated with current pulses whose amplitude is greater than 500 A.

6. Method to Claim 4 characterized in that during the plasma emission the central axis of the vacuum arc evaporator (14) is aligned to the substrate (1) to be coated.

7. Method to Claim 4 characterized in that during the plasma emission the central axis of the substrate (1) is aligned to the vacuum arc evaporator (14).

8. Method to Claim 4 characterized in that when several substrates (1) are simultaneously metallized the central axis of each substrate (1) is aligned to the vacuum arc evaporator (14).

9. Method to Claim 4 characterized in that during metallization, through controllable inlet opening (16, 17) in the vacuum chamber (13), inert gas and/or reactive gas of a low pressure is admitted to the plasma (15) and through inlet opening (17) reactive gas and/or inert gas is admitted to the substrate (1).

10. Method to one of the Claims 6 or 9 characterized in that the total substrate surface is covered against the evaporator (14) by means of a diaphragm (18) between the vacuum arc evaporator (14) and substrate (1).

11. Method to Claim 10 characterized in that potentials are set at the substrate (1) and/or the diaphragm (18) against the cathode (6) or the substrate (1) and diaphragm (18) are operated electrically insulated from each other.

12. Method to any of the Claims 4 to 11 characterized in that during metallization the substrate (1) regarding the normal to its surface has a right angle to the central axis of the vacuum arc evaporator (14).

13. Method to Claim 12 characterized in that during metallization the substrate (1) rotates on its central axis.

14. Method to any of the Claims 1 to 13 characterized in that the metallization takes place through a current-carrying coil (19) between vacuum arc evaporator (14) and substrate
(1) with the inner diameter of the coil being bigger than or equal to the substrate diameter.

15. Method to any of the Claims 1 to 13 characterized in that the metallization takes place through a curved current-carrying coil (19) between vacuum arc evaporator (14) and substrate (1) with the central axes of the evaporator (14) and the substrate or substrates (1) directed to the centre of the appropriate coil opening.

16. Method to any of the Claims 1 to 13 characterized in that the metallization takes place through several current-carrying coils (19) located on a bent between vacuum arc evaporator (14) and substrate (1) with the central axis of the evaporator (14) and the central axis of the substrate (1) directed to the centre of that coil (19) opposite the respective object.

17. Method to any of the Claims 14 to 16 characterized in that an intermediate recipient (21) is used with the coils (19) outside of this recipient (21).

18. Method to any of the Claims 1 to 9 and 12 to 17 characterized in that the substrate (1) is insulated or a certain potential is set against the cathode (6).

## Revendications

1. Procédé visant à métalliser des corps de semi-conducteurs au moyen d'une séparation réalisée dans la phase vapeur sous vide, la matière séparée étant déposée sur des substrats microélectroniques déjà structurés, tels que par ex. SiO₂ ou d'autres matériaux inorganiques ou organiques, dans les canaux et les trous creusés dans ce substrat. Ce procédé est caractérisé par l'utilisation d'un appareil évaporatoire à arc sous vide à pulsations (14) connu en général, et par une couche barrière (2) qui est séparée pour recouvrir la surface des canaux et des trous du substrat (1) en utilisant le plasma de l'appareil évaporatoire et / ou par le fait que le remplissage des canaux et des trous avec de la matière conductrice (3) s'effectue avec un autre plasma d'un tel appareil évaporatoire (14).

2. Procédé d'après la revendication n°. 1, caractérisé par le fait que la séparation de la couche barrière (2) est effectuée dans un gaz de basse pression.

3. Procédé d'après la revendication n°. 2, caractérisé par le fait que les gaz utilisés sont des gaz inertes et / ou réactionnels.

4. Procédé d'après les revendications n°. 1, 2 ou 3, caractérisé par le fait que le plasma est engendré dans un appareil évaporatoire à arc sous vide à pulsations (14) connu en général, qui comprend au moins l'anode (5), la cathode (6), l'igniteur (7), la source de courant d'impulsions (8) montée à l'extérieur d'une chambre à vide (13) et le système électronique de commande du processus (9). Le substrat (1) est exposé au plasma (15) émis par la cathode (6) et / ou par l'anode (5).

5. Procédé d'après la revendication n°. 4, caractérisé par le fait que l'appareil évaporatoire à arc sous vide (14) est mis en marche par des impulsions d'une amplitude supérieure à 500 ampères.

6. Procédé d'après la revendication n°. 4, caractérisé par le fait que, lors de l'émission du plasma, la ligne centrale de l'appareil évaporatoire à arc sous vide (14) est orientée vers le substrat (1) qui est à recouvrir.

7. Procédé d'après la revendication n°. 4, caractérisé par le fait que, lors de l'émission du plasma, la ligne centrale du substrat (1) est orientée vers l'appareil évaporatoire à arc sous vide (14).

8. Procédé d'après la revendication n°. 4, caractérisé par le fait que, lors de la métallisation simultanée de plusieurs substrats (1), les lignes centrales de chacun des substrats (1) sont orientées vers l'appareil évaporatoire à arc sous vide (14).

9. Procédé d'après la revendication n°. 4, caractérisé par le fait que, lors de la métallisation, du gaz inerte et / ou du gaz réactionnel de basse pression sont amenés au plasma (15) à travers les orifices d'admission réglables (16), (17) de la chambre à vide (13), tandis que du gaz inerte et / ou du gaz réactionnel sont amenés au substrat (1) à travers l'orifice d'admission (17).

10. Procédé d'après l'une des revendications n°. 6 ou 9, caractérisé par le fait que la surface entière du substrat est protégée de l'appareil évaporatoire (14) à l'aide d'un diaphragme (18) placé entre l'appareil évaporatoire à arc sous vide (14) et le substrat (1).

11. Procédé d'après la revendication n°. 10, caractérisé soit par le fait que des potentiels soient mis au point au substrat (1) et /ou au diaphragme (18) en face de la cathode (6) soit par une exploitation du substrat (1) et / ou du diaphragme (18) à isolement électrique réciproque.

12. Procédé d'après l'une des revendications n°. 4 à 11, caractérisé par le fait que, lors de la métallisation, le substrat (1) est placé de façon à ce qu'il forme, par rapport à la normale de sa surface, un angle droit avec la ligne centrale de l'appareil évaporatoire à arc sous vide (14).

13. Procédé d'après la revendication n°. 12, caractérisé par le fait que, lors de la métallisation, le substrat (1) effectue des rotations autour de son axe central.

14. Procédé d'après l'une des revendications n°. 1 à 13, caractérisé par le fait que la métallisation est faite à travers une bobine parcourue par le courant (19), placée entre l'appareil évaporatoire à arc sous vide (14) et le substrat (1). Le diamètre intérieur de la bobine est égal ou supérieur au diamètre du substrat.

15. Procédé d'après l'une des revendications n°. 1 à 13, caractérisé par le fait que la métallisation est faite à travers une bobine courbée parcourue par le courant (19), placée entre l'appareil évaporatoire à arc sous vide (14) et le substrat (1), les lignes centrales de l'appareil évaporatoire (14) et celles du ou des substrats (1) étant orientées vers le centre de l'ouverture de la bobine correspondante.

16. Procédé d'après l'une des revendications n°. 1 à 13, caractérisé par le fait que la métallisation est faite à travers plusieurs bobines parcourues par le courant (19)placées en courbures entre l'appareil évaporatoire à arc sous vide (14) et le substrat (1), la ligne centrale de l'appareil évaporatoire (14) et celle du substrat (1) étant orientées vers le milieu de la bobine placée en face de l'objet en question.

17. Procédé d'après l'une des revendications n°. 14 à 16, caractérisé par l'utilisation d'un récipient intermédiaire (21), où les bobines (19) se trouvent à l'extérieur du récipient (21).

18. Procédé d'après l'une des revendications n°. 1 à 9 et 12 à 17, caractérisé soit par l'isolement du substrat (1) soit par la mise au point d'un certain potentiel par rapport à la cathode (6).
